(19) Europäisches Patentamt
European Patent Office
Office européen des brevets

(11) **EP 0 727 879 A1**

(12) **DEMANDE DE BREVET EUROPEEN**

(43) Date de publication:
**21.08.1996 Bulletin 1996/34**

(51) Int Cl.⁶: **H03M 13/00**

(21) Numéro de dépôt: **96400285.1**

(22) Date de dépôt: **12.02.1996**

(84) Etats contractants désignés:
**DE ES GB IT SE**

(30) Priorité: **17.02.1995 FR 9501863**

(71) Demandeur: **ALCATEL TELSPACE**
**F-92734 Nanterre Cédex (FR)**

(72) Inventeurs:
• **Urbaniak, Olivier**
  **F-95610 Eragny s/Oise (FR)**

• **Bazet, André**
  **F-92110 Clichy (FR)**

(74) Mandataire: **Scheer, Luc et al**
**SOSPI**
**14-16, rue de la Baume**
**75008 Paris (FR)**

(54) **Dispositif d'initialisation d'un décodeur de Viterbi compris dans un récepteur de signaux transmis sous forme de paquets, récepteur et procédé d'initialisation correspondants**

(57) L'invention concerne notamment un dispositif d'initialisation d'un décodeur de Viterbi (11) compris dans un récepteur de signaux transmis sous forme de paquets, chaque paquet comprenant un mot de synchronisation ainsi que des données utiles ayant subi un codage convolutif au niveau d'un émetteur, la position des données utiles par rapport à celle du mot de synchronisation étant connue.

Le dispositif comprend :

- des moyens (12) de détection du mot de synchronisation ;

- des moyens (13) de multiplexage pour appliquer au décodeur de Viterbi (11) les signaux reçus en présence des données utiles, ainsi que, immédiatement avant et immédiatement après ces données utiles, une séquence de code (SC) générée localement, dépourvue d'erreurs et de longueur au moins égale à la longueur de troncature du décodeur de Viterbi (11).

L'invention s'applique notamment à la transmission de données en mode AMRT par satellite.

FIG.2

## Description

Le domaine de l'invention est celui des télécommunications numériques, notamment par satellite, et notamment celui des récepteurs de signaux numériques recevant des signaux codés par un codage convolutif.

Plus précisément, la présente invention concerne un dispositif d'initialisation d'un décodeur de Viterbi compris dans un étage de démodulation d'un récepteur de signaux transmis sous forme de paquets (transmission AMRT), un récepteur comprenant un tel dispositif d'initialisation, ainsi qu'un procédé mis en oeuvre pour cette initialisation.

De manière connue, afin de diminuer le taux d'erreur d'une transmission hertzienne entre un émetteur et un récepteur, par exemple par l'intermédiaire d'un satellite, on peut procéder, au niveau de l'émetteur, à un codage convolutif des données numériques à transmettre. Le décodage des données convoluées est assuré à la réception par un décodeur de Viterbi. On entend dans la suite de cette description par décodeur de Viterbi tout décodeur fonctionnant selon le critère de maximum de vraisemblance. Ce décodage s'opère après transposition en bande de base du signal reçu et la décision sur les symboles n'est généralement effectuée qu'après décodage (décision souple ou "soft decision" en anglais).

Il est connu de réaliser un codage et un décodage de ce type pour des liaisons continues dans le temps. On peut par exemple se référer à la demande de brevet français n°2.530.096 au nom de NEC CORPORATION et KOKUSAI DENSHIN DENWA CO., LTD. concernant un circuit de synchronisation pour décodeur de Viterbi exploitant un signal résultant de la différence des métriques maximum et minimum pour l'obtention de la synchronisation (l'écart moyen entre les métriques maximum et minimum a une valeur importante lorsque la synchronisation est obtenue).

L'inconvénient de ce dispositif est qu'un important nombre d'erreurs se produit à l'établissement d'une communication car, à la réception des premières données, le décodeur de Viterbi n'est pas immédiatement prêt pour leur décodage. On accepte de ce fait un nombre important d'erreurs à l'établissement de la communication. Ceci n'est pas particulièrement gênant dans une transmission en continu mais n'est pas concevable dans une transmission en mode AMRT.

Dans une transmission en mode AMRT, chaque paquet transmis comprend un mot de synchronisation, encore appelé mot unique, ainsi que des données utiles, le nombre des données utiles ainsi que la position de ces données utiles par rapport à celle du mot de synchronisation étant connus.

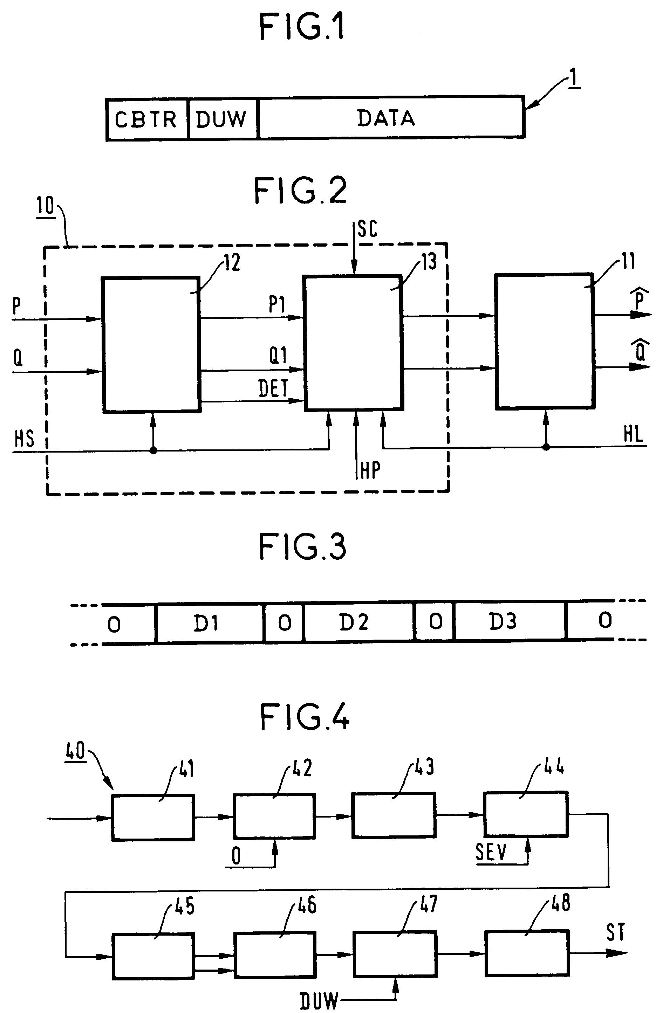

La figure 1 représente la structure d'un paquet de données transmises tel qu'il se présente dans une transmission en mode AMRT.

Le paquet représenté, généralement référencé par 1, comporte un préambule compris dans des champs CBTR et DUW, ainsi que des données utiles comprises dans le champ DATA. Le champ CBTR comporte des bits permettant une récupération de porteuse et une récupération de rythme. Le champ DUW comporte les symboles du mot de synchronisation et le champ DATA comporte les bits de données utiles.

Dans ce paquet, le mot de synchronisation DUW est donc compris dans le préambule et son dernier bit est immédiatement suivi par le premier bit de données utiles.

Si l'on veut pouvoir coder les données utiles par un codage convolutif, il faut que le décodeur de Viterbi compris dans un récepteur de ce paquet soit prêt au décodage des données utiles dès détection du mot de synchronisation, afin d'éviter qu'un paquet d'erreurs ne se produise à la réception des premières données utiles. Ainsi, la solution précitée consistant à synchroniser le décodeur de Viterbi en observant la divergence des métriques maximum et minimum est trop longue en temps et ne peut donc convenir pour une transmission en mode AMRT.

Il est par ailleurs connu, par l'article de Richard L. Moat intitulé "Acts Baseband Processing", Globecom '86, IEEE Global Telecommunications Conference, Communications Broadening Technology Horizons, Conference Record CH2298 - 9, Houston, vol.1, pages 578-583, de prévoir une séquence de vidage des données inscrites dans un décodeur de Viterbi. Cette séquence est constituée par les premiers mots de code reçus d'une séquence, mémorisés dans une mémoire RAM et ayant déjà subi un décodage.

L'inconvénient de cette technique est qu'elle ne sert pas à préparer le décodeur à recevoir des mots de code et surtout que les mots reçus ne sont pas nécessairement des mots de code car des erreurs de transmission ont pu se produire. Dans ce cas, le décodeur de Viterbi peut diverger et les derniers mots décodés du bloc ne correspondent pas à ceux de la source.

La présente invention a pour objectif de remédier à ces inconvénients.

Plus précisément, un des objectifs de l'invention est de fournir un dispositif d'initialisation d'un décodeur de Viterbi compris dans un récepteur de signaux transmis sous forme de paquets, les paquets reçus pouvant provenir d'émetteurs distincts et étant irrégulièrement espacés dans le temps du fait de l'existence d'un temps de garde entre les paquets reçus. L'initialisation du décodeur doit permettre d'assurer un décodage correct de toutes les données utiles.

Selon l'invention, cet objectif est atteint grâce à un dispositif d'initialisation d'un décodeur de Viterbi compris dans un récepteur de signaux transmis sous forme de paquets, chaque paquet comprenant un mot de synchronisation ainsi que des données utiles ayant subi un codage convolutif au niveau d'un émetteur, la position des données utiles par rapport à celle du mot de synchronisation étant connue, le dispositif comprenant :

- des moyens de détection du mot de synchronisation ;
- des moyens de multiplexage pour appliquer au décodeur de Viterbi les signaux reçus en présence des données utiles et pour appliquer au décodeur de Viterbi, immédiatement avant et immédiatement après ces données utiles, une séquence de code générée localement, dépourvue d'erreurs et de longueur au moins égale à la longueur de troncature du décodeur de Viterbi.

L'invention concerne également un récepteur comprenant un tel dispositif d'initialisation, ainsi qu'un procédé d'initialisation d'un décodeur de Viterbi.

La présente invention sera mieux comprise à la lecture de la description suivante d'un mode de réalisation préférentiel, donné à titre illustratif et non limitatif, et des dessins annexés dans lesquels :

- la figure 1 représente la structure d'un paquet de données tel qu'il se présente dans une transmission en mode AMRT ;
- la figure 2 est un schéma synoptique d'un mode de réalisation préférentiel d'un dispositif d'initialisation selon l'invention ;
- la figure 3 représente un flot continu de symboles appliqué au décodeur de Viterbi de la figure 2 ;
- la figure 4 est un schéma synoptique d'un mode de réalisation préférentiel d'un émetteur de signaux en mode AMRT adapté pour communiquer avec un récepteur comprenant un dispositif d'initialisation selon la figure 2.

La figure 1 a été décrite précédemment en référence à l'état de la technique.

La figure 2 est un schéma synoptique d'un mode de réalisation préférentiel d'un dispositif d'initialisation selon l'invention. Ce dispositif d'initialisation, généralement référencé par 10, coopère avec un décodeur de Viterbi 11 compris dans un récepteur de signaux transmis sous forme de paquets. De manière classique, chaque paquet comprend un mot de synchronisation ainsi que des données utiles, la position des données utiles par rapport à celle du mot de synchronisation étant connue. Les différents paquets reçus par le récepteur ont par exemple une structure identique à celui de la figure 1. L'invention propose de réaliser un codage convolutif des données au niveau d'un émetteur de tels paquets, si bien que le champ DATA comprend des symboles ayant subi ce codage convolutif.

Le dispositif d'initialisation de la figure 2 reçoit en entrée deux trains numériques P et Q en provenance d'un démodulateur situé en amont et non représenté. Il comprend notamment des moyens 12 de détection du mot de synchronisation présent dans chaque paquet reçu. Ces moyens de détection sont par exemple constitués d'un détecteur d'énergie suivi par un corrélateur fournissant un signal DET lorsque le mot de synchronisation est reconnu. On peut par exemple se référer à la demande de brevet français n°2.707.128 déposée le 29 juin 1993 au nom du même déposant. Le signal DET est par exemple constitué par une impulsion de durée égale à celle d'un symbole, marquant la présence du premier symbole de données utiles. Les moyens de détection peuvent également assurer une levée d'ambiguïté de phase sur les trains P et Q et fournir en sortie des trains P1 et Q1 correspondant aux trains P et Q ayant subi cette levée d'ambiguïté. Les trains P1 et Q1 (ou éventuellement les trains P et Q en l'absence de levée d'ambiguïté) ainsi que le signal de détection DET sont appliqués à des moyens 13, appelés moyens de multiplexage, qui fournissent au décodeur de Viterbi 11 les signaux reçus, en présence des données utiles, et qui appliquent à ce même décodeur de Viterbi 11, immédiatement avant et immédiatement après ces données utiles, une séquence de code SC générée localement, dépourvue d'erreurs et de longueur au moins égale à la longueur de troncature du décodeur de Viterbi 11. Ainsi, en notant X et Y les signaux appliqués au décodeur 11, X et Y sont respectivement égaux à P1 et Q1 (P et Q) en présence des données utiles et correspondent à la séquence de code SC de part et d'autre de ces séquences codées, sur au moins la longueur de troncature du décodeur 11. La longueur de troncature ("truncation depth" en anglais) du décodeur 11 est définie comme étant le nombre N de symboles successifs à fournir à ce décodeur 11 pour que le symbole de rang N+1 n'ait plus d'incidence sur le décodage du symbole de rang 1. Ce symbole de rang 1 est alors un symbole décidé. Plus la longueur de troncature est importante, plus le décodage est performant et le taux d'erreur faible.

La longueur de troncature dépend du type de codeur utilisé à l'émission, du poinçonnage éventuel réalisé et de la qualité du décodage souhaitée. A titre d'exemple, la longueur de troncature est égale à 5 fois la longueur de contrainte du codeur utilisé à l'émission pour un codage de rendement 1/2 et de 10 fois la longueur de contrainte pour un codage de rendement 3/4.

La séquence de code SC correspond à une séquence qui doit pouvoir être issue du codeur convolutif utilisé à l'émission. L'application de cette séquence au décodeur 11 avant les données utiles prépare ce dernier à la réception des premières données utiles. Lorsque le décodeur de Viterbi a reçu cette séquence codée, générée localement et donc exempte d'erreur, il a en mémoire le meilleur chemin de décodage, appelé chemin survivant. L'initialisation du décodeur est donc d'une part obtenue par application de cette séquence de code avant les données utiles. Le décodeur traite cette séquence de code en tant que données codées et, lorsqu'il a traité un nombre de données correspondant à sa longueur de troncature, il est en condition pour traiter les données utiles. On réalise donc une préparation du décodeur à la réception des données utiles.

Dans un mode de réalisation préférentiel, parce que particulièrement simple à mettre en oeuvre, la séquence de code générée localement est constituée de niveaux logiques identiques, par exemple une suite de niveaux logiques 0. En effet, tout codeur convolutif est susceptible de fournir une suite de niveaux logiques bas. Ce mode de réalisation consiste par exemple à relier les entrées du décodeur à la masse pendant les durées appropriées.

On notera également que l'invention permet d'assurer un décodage correct des dernières données utiles en fournissant au décodeur de Viterbi une séquence de code, après le dernier symbole de données utiles, de longueur au moins égale à la longueur de troncature du décodeur de Viterbi 11. On assure ainsi un décodage correct des dernières données utiles. Cette séquence de code est préférentiellement, pour des raisons de simplification de réalisation, la même que celle appliquée au décodeur avant les données utiles.

Dans un mode de réalisation préférentiel, la séquence de code générée localement est fournie continuellement au décodeur de Viterbi, sauf en présence des données utiles, de sorte que le décodeur de Viterbi ne voie qu'un flot continu de données à décoder. La réalisation du circuit d'initialisation s'en trouve ainsi grandement simplifiée : en présence de données utiles codées, dont la position est détectée par le mot de synchronisation, ces données codées sont fournies au décodeur de Viterbi, alors qu'en l'absence de données utiles codées, le décodeur de Viterbi 11 reçoit la séquence de code générée localement.

Les moyens 13 peuvent donc être considérés dans une première approche comme des moyens de multiplexage appliquant aux entrées du décodeur 11 soit les données utiles codées, lorsque celles-ci sont présentes, soit la séquence de code SC.

La figure 3 représente un flot continu de symboles appliqué au décodeur de Viterbi. Les paquets de données utiles sont notés Di (D1 à D3 pour 3 paquets consécutifs reçus) et les séquences de code constituées de niveaux logiques "0".

De manière générale, l'invention suppose que la position des données utiles par rapport au mot de synchronisation et leur longueur soient connues. L'invention s'applique notamment aux transmissions AMRT dans lesquelles chacun des paquets comporte un préambule et où le mot de synchronisation est compris dans chacun de ces préambules. Le mot de synchronisation peut notamment précéder les données utiles, la structure générale de la trame étant alors celle donnée à la figure 1.

De manière avantageuse, les paquets reçus comportent chacun un postambule destiné à permettre une transition entre la fin des données utiles et la séquence de code générée localement. Ce postambule constitue la fin des données utiles et est constitué par une convolution des dernières données utiles à transmettre avec une séquence (par exemple une séquence de "0"), appelée séquence de vidage, de longueur au moins égale à k-1, où k est la longueur de contrainte du codeur convolutif utilisé à l'émission. A titre d'exemple, si k = 7, une insertion d'une séquence de six états logiques "0" est réalisée au niveau de l'émetteur, avant le codeur convolutif, afin de vider le codeur des dernières six données utiles à transmettre, comprises dans le codeur convolutif. Ainsi, si 100 bits de données utiles sont à transmettre dans un paquet, le champ de données DATA de la figure 1 contient 212 (106*2) bits pour un codage convolutif de rendement 1/2 non suivi d'un poinçonnage.

La figure 4 est un schéma synoptique d'un mode de réalisation préférentiel d'un émetteur de signaux en mode AMRT adapté pour communiquer avec un récepteur comprenant un dispositif d'initialisation selon la figure 2.

L'émetteur, généralement référencé par 40, comporte un brouilleur 41 facultatif auquel sont appliquées les données utiles à transmettre en provenance d'une source. Les données brouillées sont appliquées à des premiers moyens d'insertion 42 qui, immédiatement avant le premier bit des données utiles, insèrent un état logique "0" (profondeur du codeur différentiel -1) dont la fonction sera donnée par la suite.

Le signal de sortie des premiers moyens d'insertion 42 est appliqué à un codeur différentiel 43 suivi par des seconds moyens d'insertion 44 qui insèrent une séquence SEV de longueur au moins égale à k-1, avec k la longueur de contrainte d'un codeur convolutif 45. Les signaux de sortie des seconds moyens d'insertion 44 sont appliqués au codeur convolutif 45, ici de rendement 1/2 et de longueur de contrainte 7. Le codeur convolutif 45 peut avoir pour polynôme générateur G = (171, 133), exprimé en octal.

Les symboles codés issus du codeur convolutif 45 sont appliqués à un dispositif de poinçonnage 46 ("puncture logic" en anglais) facultatif, réalisant également une mise en série des symboles codés, suivi par un étage 47 d'insertion du mot de synchronisation DUW. Le signal résultant est appliqué à des moyens de modulation 48 de type MDP-4 (Modulation de Phase à 4 états) fournissant un signal transmis ST sous forme de paquets.

La présence du codeur différentiel 43, et d'un décodeur correspondant à la réception, par exemple placé après le décodeur de Viterbi, est nécessaire pour une transmission de données convoluées en AMRT afin de se prémunir des sauts de phase pouvant affecter la transmission en cours de paquet. Les premiers moyens d'insertion 42 ont pour fonction d'assurer une initialisation du décodeur différentiel, ici à deux dimensions.

A titre d'exemple, les équations d'un codeur différentiel à deux dimensions sont les suivantes :

$$P_i = (\overline{A_i}.\overline{B_i}.P_{i-1}) + (A_i.\overline{B_i}.\overline{Q_{i-1}}) + (A_i.B_i.\overline{P_{i-1}}) + (\overline{A_i}.B_i.Q_{i-1})$$

$$Q_i = (\overline{A}_i.\overline{B}i.Q_{i-1}) + (A_i.\overline{B}i.P_{i-1}) + (A_i.B_i.\overline{Q_{i-1}}) + (\overline{A}i.B_i.\overline{P_{i-1}})$$

Les équations du décodeur différentiel à deux dimensions sont dans ce cas :

$$A_i = (\overline{P}_i.\overline{Q}_i.Q_{i-1}) + (P_i.\overline{Q}_i.\overline{P_{i-1}}) + (P_i.Q_i.\overline{Q_{i-1}}) + (\overline{P}_i.Q_i.P_{i-1})$$

$$B_i = (\overline{P}_i.\overline{Q}_i.P_{i-1}) + (P_i.\overline{Q}_i.Q_{i-1}) + (P_i.Q_i.\overline{P_{i-1}}) + (\overline{P}_i.Q_i.\overline{Q_{i-1}})$$

avec P et Q les bits issus du codeur différentiel et appliqués à l'entrée du décodeur différentiel, A et B les bits appliqués à l'entrée du codeur différentiel et issus du décodeur différentiel, $\overline{X}$ le complément de X, $X_{i-1}$ le bit considéré à l'instant t-1 et $X_i$ le bit considéré à l'instant t.

On parle de codeur et de décodeur à deux dimensions car tout bit issu du codeur est dépendant seulement du bit qui le précède.

Ainsi, grâce à l'initialisation réalisée, si $a_0$ est le premier bit de données utiles, $a_{-1}$ est forcé à "0" afin d'assurer un décodage différentiel correct de $a_0$.

Par ailleurs, en référence à la figure 2, les moyens de multiplexage 13 peuvent avantageusement recevoir l'horloge symbole récupérée HS, également appliquée au détecteur 12, une horloge locale fixe HL, également appliquée au décodeur de Viterbi 11, ainsi qu'une fenêtre logique prédictive HP marquant l'apparition probable des symboles de données utiles. La fenêtre prédictive HP est prévue dans tout récepteur de signaux AMRT pour signaler qu'un paquet de données utiles devrait être présent, compte tenu de la fréquence d'émission de ces paquets. La position de cette fenêtre est précisément ajustée par le signal DET pour commander l'insertion de la séquence de code SC.

La fenêtre prédictive HP est notamment utilisée pour commander l'application de la séquence de code SC au décodeur de Viterbi 11 avant l'apparition des données utiles (c'est à dire en l'absence de détection du mot de synchronisation). Cela est particulièrement utile à l'établissement d'une communication (lorsqu'il n'y a pas de paquet de données antécédent) ou lorsque le mot de synchronisation précède de peu les données utiles.

Les moyens 13 de multiplexage comprennent préférentiellement une FIFO lue par l'horloge locale fixe HL afin de réaliser les opérations d'insertion de la séquence de code SC en étant insensible aux décrochages de l'horloge récupérée HS. Les écritures dans cette FIFO des symboles reçus se font au rythme de l'horloge récupérée HS.

Avantageusement, les moyens 13 assurent également un démultiplexage des données utiles, afin de diviser par deux la fréquence de travail du décodeur 11. Ils peuvent également assurer une insertion de bits nuls (bits non pris en compte pour le calcul des métriques) lors de l'utilisation d'un codage convolutif poinçonné, afin de faire fonctionner le décodeur 11 selon un code de rendement 1/2.

Le décodeur de Viterbi utilisé peut notamment être le circuit Q1650 de Qualcomm (nom protégé) et on se reportera avantageusement à la notice technique de ce circuit qui décrit différents aspects de codage et de décodage exploités dans l'invention.

L'invention concerne également un récepteur de données numériques comportant un dispositif d'initialisation tel que décrit ci-dessus. Ce récepteur peut notamment être utilisé pour la réception de données transmises par satellite.

L'invention concerne également un procédé d'initialisation d'un décodeur de Viterbi compris dans un récepteur de signaux transmis sous forme de paquets, chaque paquet comprenant un mot de synchronisation ainsi que des données utiles ayant subi un codage convolutif au niveau d'un émetteur, la position des données utiles par rapport à celle du mot de synchronisation étant connue, ce procédé consistant à :

- détecter le mot de synchronisation ;
- appliquer au décodeur de Viterbi les signaux reçus en présence des données utiles ;
- appliquer au décodeur de Viterbi, immédiatement avant et immédiatement après les données utiles, une séquence de code générée localement, dépourvue d'erreurs et de longueur au moins égale à la longueur de troncature du décodeur de Viterbi.

## Revendications

1. Dispositif d'initialisation d'un décodeur de Viterbi (11) compris dans un récepteur de signaux transmis sous forme de paquets, chaque paquet comprenant un mot de synchronisation (DUW) ainsi que des données utiles (DATA) ayant subi un codage convolutif au niveau d'un émetteur (40), la position desdites données utiles (DATA) par rapport à celle dudit mot de synchronisation (DUW) étant connue, ledit dispositif comprenant :

   - des moyens (12) de détection dudit mot de synchronisation (DUW) ;
   - des moyens (13) de multiplexage pour appliquer audit décodeur de Viterbi (11) lesdits signaux reçus en présence desdites données utiles (DATA) et pour appliquer audit décodeur de Viterbi (11), immédiatement avant et immédiatement après lesdites données utiles (DATA), une séquence de code (SC) générée localement, dépourvue d'erreurs et de longueur au moins égale à la longueur de troncature dudit décodeur de Viterbi (11).

2. Dispositif selon la revendication 1, caractérisé en ce que ladite séquence de code (SC) générée localement est fournie continuellement audit décodeur de Viterbi (11), sauf en présence desdites données utiles (DATA), de sorte que ledit décodeur de Viterbi (11) ne voie qu'un flot continu de données à décoder.

3. Dispositif selon l'une des revendications 1 et 2, caractérisé en ce que ladite séquence de code (SC) générée localement est constituée de niveaux logiques identiques.

4. Dispositif selon l'une des revendications 1 à 3, caractérisé en ce que chacun desdits paquets comporte un préambule (CBTR, DUW) dans lequel est inscrit ledit mot de synchronisation (DUW).

5. Dispositif selon l'une des revendications 1 à 4, caractérisé en ce que ledit mot de synchronisation (DUW) précède lesdites données utiles (DATA) dans lesdits paquets.

6. Dispositif selon l'une des revendications 1 à 5, caractérisé en ce que chacun desdits paquets comporte un postambule constitué par une convolution des dernières données utiles à transmettre avec une séquence de longueur au moins égale à k-1, où k est la longueur de contrainte du codeur convolutif (45) utilisé à l'émission.

7. Dispositif selon la revendication 6, caractérisé en ce que ladite séquence de longueur au moins égale à k-1 est constituée par une séquence d'états logiques "0".

8. Dispositif selon l'une des revendications 1 à 7, caractérisé en ce que ledit codeur convolutif (45) a pour polynôme générateur G = (171, 133).

9. Dispositif selon l'une des revendications 1 à 8, caractérisé en ce que lesdits moyens (13) de multiplexage comprennent une FIFO lue par une horloge locale fixe (HL) pour réaliser les opérations d'insertion de ladite séquence de code (SC) en étant insensible aux décrochages de l'horloge récupérée (HS).

10. Récepteur de données numériques, caractérisé en ce qu'il comporte un dispositif selon l'une des revendications 1 à 9.

11. Récepteur selon la revendication 10, caractérisé en ce qu'il est utilisé pour la réception de données transmises par satellite.

12. Procédé d'initialisation d'un décodeur de Viterbi (11) compris dans un récepteur de signaux transmis sous forme de paquets, chaque paquet comprenant un mot de synchronisation (DUW) ainsi que des données utiles (DATA) ayant subi un codage convolutif au niveau d'un émetteur (40), la position desdites données utiles (DATA) par rapport à celle dudit mot de synchronisation (DUW) étant connue, ledit procédé consistant à :

- détecter ledit mot de synchronisation (DUW) ;
- appliquer audit décodeur de Viterbi (11) lesdits signaux reçus en présence desdites données utiles (DATA) ;
- appliquer audit décodeur de Viterbi (11), immédiatement avant et immédiatement après lesdites données utiles (DATA), une séquence de code (SC) générée localement, dépourvue d'erreurs et de longueur au moins égale à la longueur de troncature dudit décodeur de Viterbi (11).

# FIG.1

| CBTR | DUW | DATA |
|------|-----|------|

1

# FIG.2

# FIG.3

| O | D1 | O | D2 | O | D3 | O |
|---|----|----|----|----|----|----|

# FIG.4

EP 0 727 879 A1

Office européen
des brevets

**RAPPORT DE RECHERCHE EUROPEENNE**

Numero de la demande
EP 96 40 0285

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| D,A | GLOBECOM '86: IEEE GLOBAL TELECOMMUNICATIONS CONFERENCE. COMMUNICATIONS BROADENING TECHNOLOGY HORIZONS. CONFERENCE RECORD (CAT. NO.86CH2298-9), HOUSTON, TX, USA, 1-4 DEC. 1986, 1986, NEW YORK, NY, USA, IEEE, USA, pages 578-583 vol.1, XP000565218 MOAT R L: "ACTS baseband processing (satellite system)" * abrégé * * page 579, colonne de gauche, ligne 30 - ligne 43 * * page 579, colonne de droite, ligne 21 - page 580, colonne de gauche, ligne 37 * * page 580, colonne de droite, ligne 36 - ligne 61; figures 2,3,7 * --- | 1,3-5, 8-12 | H03M13/00 |
| A | MILCOM 86: 1986 IEEE MILITARY COMMUNICATIONS CONFERENCE. COMMUNICATIONS-COMPUTERS: TEAMED FOR THE '90'S. CONFERENCE RECORD (CAT. NO.86CH2323-4), MONTEREY, CA, USA, 5-9 OCT. 1986, 1986, NEW YORK, NY, USA, IEEE, USA, pages 12.6/1-5 vol.1, XP000565219 CLARKE K C ET AL: "Multi-channel Viterbi decoder LSI development" * page 12.6.1, colonne de gauche, ligne 1 - colonne de droite, ligne 5 * * page 12.6.4, colonne de gauche, ligne 44 - colonne de droite, ligne 41 * * figures 1,2 * --- | 1,3,7,8, 10,12 | |
| A | WO-A-94 15427 (MOTOROLA) 7 Juillet 1994 * page 4, ligne 21 - ligne 24 * * page 4, ligne 39 - page 5, ligne 26 * * page 7, ligne 1 - ligne 14 * * figures 1,2,4 * --- -/-- | 1-6,10 | |

**DOMAINES TECHNIQUES RECHERCHES (Int.Cl.6)**

H03M

Le présent rapport a été établi pour toutes les revendications

| Lieu de la recherche | Date d'achèvement de la recherche | Examinateur |
|---|---|---|
| LA HAYE | 7 Juin 1996 | Pieper, T |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P04C02)

8

Office européen
des brevets

**RAPPORT DE RECHERCHE EUROPEENNE**

Numéro de la demande

EP 96 40 0285

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | WO-A-89 08884 (MA COM GOV SYSTEMS) 21 Septembre 1989 <br> * page 6, ligne 18 - page 9, ligne 7; revendication 1; figures 1,2,3A * <br> --- | 1,2,9, 10,12 | |
| A | US-A-4 583 078 (SHENOY AJIT ET AL) 15 Avril 1986 <br> * colonne 4, ligne 31 - ligne 34 * <br> * colonne 6, ligne 29 - ligne 39 * <br> * figures 5,6 * <br> --- | 1,3,11, 12 | |
| A | NEC RESEARCH AND DEVELOPMENT, JAN. 1988, JAPAN, <br> no. 88, Janvier 1988, ISSN 0547-051X, pages 12-19, XP000566413 <br> OTANI S ET AL: "Development of a variable rate FEC LSI for satellite communications" <br> * abrégé * <br> * page 12, colonne de gauche, ligne 28 - colonne de droite, ligne 16 * <br> * page 17, colonne de gauche, ligne 8 - ligne 25; figures 1,10 * <br> --- | 1,2,11, 12 | |
| A | WO-A-92 06429 (TITAN CORP) 16 Avril 1992 <br> * page 6, ligne 22 - page 7, dernière ligne * <br> * page 13, alinéa 3; figures 2,7,8 * <br> ----- | 1,9 | DOMAINES TECHNIQUES RECHERCHES (Int.Cl.6) |

Le présent rapport a été établi pour toutes les revendications

| Lieu de la recherche | Date d'achèvement de la recherche | Examinateur |
|---|---|---|
| LA HAYE | 7 Juin 1996 | Pieper, T |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)